# EUROPEAN PATENT SPECIFICATION

(11) **EP 4 215 926 B1**
(45) Date of publication and mention of the grant of the patent: **11.11.2026**
(21) Application number: 22152165.1
(22) Date of filing: 19.01.2022
(51) Int. Cl.: G01R 29/08, G01R 33/032, G01R 33/26

(54) **MICROWAVE SIGNAL ANALYSIS BASED ON BEAM-SCANNED QUANTUM SENSOR**
MIKROWELLENSIGNALANALYSE BASIEREND AUF EINEM STRAHLABGETASTETEN QUANTENSENSOR
ANALYSE DE SIGNAUX MICRO-ONDES BASÉE SUR UN CAPTEUR QUANTIQUE À BALAYAGE DE FAISCEAU

(43) Date of publication of application: 26.07.2023
(73) Proprietor: Rohde & Schwarz GmbH & Co. KG, 81671 München (DE)
(72) Inventor: Ruster, Thomas, 81543 Munich (DE)
(74) Representative: Novagraaf Group

(56) References cited:
- WO-A1-2021/243260
- US-A1- 2015 338 718
- US-A1- 2017 322 244
- US-A1- 2021 109 010
- US-B2- 10 823 775
- ANDERSON G W ET AL: "ADVANCED CHANNELIZATION TECHNOLOGY FOR RF, MICROWAVE, AND MILLIMETERWAVE APPLICATIONS", PROCEEDINGS OF THE IEEE, IEEE. NEW YORK, US, vol. 79, no. 3, 1 March 1991 (1991-03-01), pages 355 - 388, XP000222678, ISSN: 0018-9219, DOI: 10.1109/5.75091

## Description

### Technical Field

The present disclosure relates to signal analysis in microwave communication, and in particular to a measurement system for real-time analysis of radio frequency (RF) signals and a corresponding method.

### Background Art

Atom-based quantum effects may be used in developing quantum sensors for various physical quantities, as is known in the art.

Detection of microwave signals based on quantum sensors such as atomic vapor cells commonly involves a pulsed readout, wherein a laser beam is repeatedly turned off and on for pumping and readout of the atomic vapor. In such detection schemes, ongoing laser operation inhibits microwave detection, resulting in intermittent detection.

WO 2021/243260 A1 discloses a measurement system for analyzing an RF signal in accordance with the preamble of independent claim 1.

### Summary

The present disclosure therefore strives to improve an RF signal analysis of the background art. The objective is achieved by the embodiments as defined by the appended independent claims. Preferred embodiments are set forth in the dependent claims and in the following description and drawings.

A first aspect of the present disclosure relates to a measurement system for analyzing an RF signal. The system comprises a sensing medium, including at least one constituent being which is pumped to an initial energy state, and being excitable from the initial energy state to a higher energy state by exposure to an electric and/or magnetic field. The system further comprises an optical pump configured to pump the at least one constituent of the medium to the initial energy state. The system further comprises an antenna configured to expose the medium to an electromagnetic field of the RF signal. The system further comprises an optical processor configured to displace a probing light (which may be identical to the pump light or not) transversely along a spatial dimension of the medium in accordance with a displacement cycle. The system further comprises an optical detector configured to (preferably continuously) detect an optical property of light emanating from the pumped medium, as a result of the probing light.

The system further comprises a field generator configured to expose the medium to a static electric or magnetic field, a strength of which defines an absorption spectrum of the medium.

The strength of the generated field has a gradient along said spatial dimension of the medium.

The field generator may comprise a permanent magnet.

The optical processor may comprise an acousto-optic deflector, AOD, for diffracting the generated light along the spatial dimension of the medium. A diffraction angle of the diffracted light may vary over the displacement cycle in accordance with a linear transverse displacement of the pump light along the spatial dimension of the medium. An optical lens may be provided, configured to collimate a higher order of diffraction of the diffracted light onto the medium. Furthermore, the optical lens may be arranged to transform the diffraction angle of the AOD to a displacement along the spatial dimension of the medium.

The optical processor may further comprise a blocker for absorbing a zeroth order of diffraction of the diffracted light.

The displacement cycle has a period in the order of microseconds to milliseconds.

The medium may comprise an alkali metal enclosed in an atomic vapor cell. The at least one constituent of the medium may comprise atoms or ions in a buffer gas. The light emanating from the pumped medium may comprise a pump light transmission through the medium having a cross-sectional intensity distribution depending on a frequency of the electromagnetic field of the RF signal.

The medium may comprise a Nitrogen vacancy, NV, diamond. The at least one constituent of the medium may comprise point defects. The light emanating from the pumped medium may comprise a light emission of the medium having a directional intensity distribution depending on the frequency of the electromagnetic field of the RF signal.

The pump may comprise at least one coherent optical light source.

The detector may comprise at least one charge-coupled device, CCD, chip extending across a cross-section of the light emanating from the pumped medium. The detected optical property may comprise a cross-sectional intensity distribution of the light emanating from the pumped medium.

The system may further comprise a digital processor configured to reconstruct the RF signal in real-time in dependence of the detected optical property.

A second aspect of the present disclosure relates to a method of analyzing an RF signal. The method comprises pumping at least one constituent of a sensing medium to an initial energy state. The at least one constituent is further excitable from the initial energy state to a higher energy state by exposure to an electric and/or magnetic field. The method further comprises exposing the medium to an electromagnetic field of the RF signal. The method further comprises displacing the pump light transversely along a spatial dimension of the medium in accordance with a displacement cycle. The method further comprises continuously detecting an optical property of light emanating from the pumped medium. The displacement cycle has a period in the order of microseconds to miliseconds, wherein the method further comprises sweeping the position of the probing light across the sensing medium such that the sensing medium is pumped and emanating light in one region and at the same time interacts with the RF signal in another region, during the displacement cycle. The method further comprises exposing the medium to a static electric or magnetic field, a strength of which defining an absorption spectrum of the medium, and having a gradient along said spatial dimension of the medium.

### Advantageous Effects

The present disclosure provides a measurement system for analyzing RF/microwave signals that avoids intermittence of detection by a cyclic transverse displacement of a laser beam along a spatial dimension of a sensing medium.

In other words, it is possible to sweep the position of the laser beam across the sensing medium (beam scanning) such that the medium is pumped and read-out somewhere without interruption, and at the same time interacts with the RF/microwave signal elsewhere.

For spectrum analysis, it is possible to sweep the position of the laser beam across a field gradient. This is easier to implement compared to classical spectrum analysis wherein a magnetic/electric field is varied over time to measure a spectrum. Note that, for real-time spectrum analysis, the direction of the field gradient of the invention is preferably different from the sweep direction, such that the entire frequency range can be detected at the same time.

Compared to classical RF/microwave detection schemes, a superior dynamic range or sensitivity may be achieved, in particular by intensity modulation of the laser beam.

The technical effects and advantages described above in relation with the measurement system for analyzing an RF signal equally apply to the method of analyzing an RF signal having corresponding features.

### Brief Description of Drawings

The above-described aspects and implementations will now be explained with reference to the accompanying drawings, in which the same or similar reference numerals designate the same or similar elements.

The features of these aspects and implementations may be combined with each other unless specifically stated otherwise.

The drawings are to be regarded as being schematic representations, and elements illustrated in the drawings are not necessarily shown to scale. Rather, the various elements are represented such that their function and general purpose become apparent to those skilled in the art.
FIG. 1 illustrates a measurement system in accordance with the present disclosure for analyzing an RF signal;
FIG. 2 illustrates a periodic displacement cycle in accordance with the present disclosure of the system 1 of FIG. 1; and
FIG. 3 illustrates a flow chart of a method in accordance with the present disclosure for analyzing an RF signal.

### Detailed Description of Embodiments

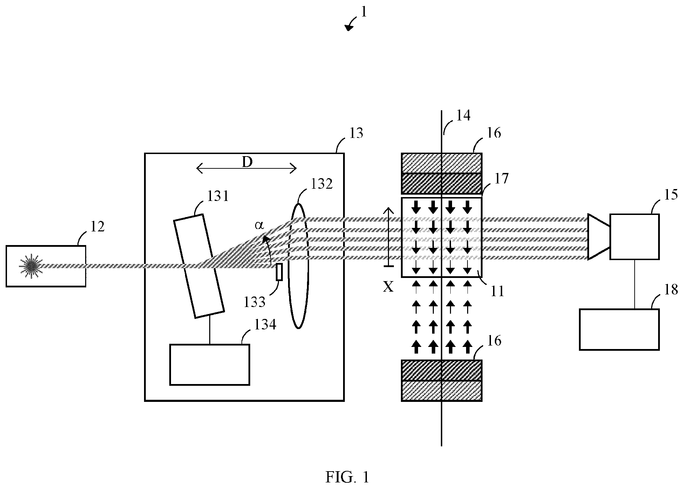

FIG. 1 illustrates a measurement system 1 in accordance with the present disclosure for analyzing an RF signal.

In Fig 1, a case is shown where the laser is displaced along a field gradient. While this might be a useful use case and is according to the claimed subject-matter, a real-time spectrum analysis scheme preferably has a gradient direction orthogonal to the sweep direction of the laser, not necessarily according to the claimed subject-matter. Likewise not according to the claimed subject-matter, sweeping of the laser beam along a spatial axis can also be applied without a field gradient being present at all (to e.g. get real-time field detection of a single MW frequency).

The system 1 comprises a sensing medium 11, including at least one constituent optically pumped to an initial energy state, and being excitable from the initial energy state to a higher energy state by exposure to an electric and/or magnetic field (which is the field of a RF signal to be analysed).

In particular, the medium 11 may comprise an alkali metal enclosed in an atomic vapor cell 17, and the at least one constituent of the medium 11 may comprise atoms or ions in a buffer gas.

The buffer gas ensures that the atoms/ions remain in a respective section of the cell 17 during a displacement cycle. According to an alternative implementation (not shown), the medium 11 may comprise a Nitrogen vacancy, NV, diamond, and the at least one constituent of the medium 11 may comprise point defects.

The system 1 further comprises an optical pump 12 configured to pump the at least one constituent of the medium 11 to the initial energy state.

The pump 12 may comprise at least one coherent optical light source.

In particular, the pump 12 may comprise a single coherent optical light source for pumping and optionally also the readout of the medium 11. Alternatively, the pump 12 may comprise a first coherent optical light source for pumping and a second coherent optical light source for readout (probing). For example, the respective coherent optical light source may comprise a laser.

The system 1 further comprises an antenna 14 configured to expose the medium 11 to an electromagnetic field of the RF signal.

In particular, the antenna 14 may comprise a waveguide such as a metallic wire (shown in FIG. 1) around which a near field may evolve responsive to the RF signal. Alternatively, the antenna 14 may comprise a microwave antenna (not shown) such as a reflector antenna, horn antenna, or the like. Using a single antenna ensures that a time-dependency of the RF signal under analysis is consistent across all regions of the cell.

The system 1 further comprises an optical processor 13 configured to displace the pump or the probing light transversely along a spatial dimension *X* of the medium 11 in accordance with a displacement cycle.

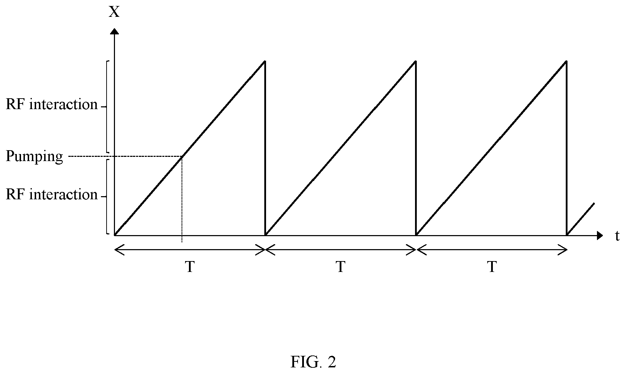

In particular, the displacement cycle has a period *T* in the order of microseconds to milliseconds (see FIG. 2 for details).

For example, the optical processor 13 may comprise an acousto-optic deflector, AOD 131, for diffracting the generated light along the spatial dimension *X* of the medium 11. In FIG. 1, said spatial dimension *X* is indicated by an arrow pointing upwardly along the medium 11.

An AOD as used herein may refer to a Bragg cell, i.e., an optically transparent element configured to diffract incident light using an acousto-optic effect. For example, a piezoelectric transducer driven by an oscillating electric signal may give rise to sound waves of wavelength *Λ* that modulate an index of refraction *n* of a crystal material such as quartz. Incident light of wavelength *λ* in vacuum scatters off the resulting periodic index modulation, giving rise to diffraction.

An optical lens 132 at distance *D* may be configured to collimate a higher order of diffraction of the diffracted light onto the medium 11. In particular, the higher order of diffraction relates to the *m* = +*1* diffraction order (see FIG. 2 below for details). A further purpose of the optical lens is to transform the angle into a displacement. It is true that the lens may also collimate a focused beam, or focus a collimated beam. In order to compensate for this effect, an additional lens may be provided (e.g. before the AOD).

The optical processor 13 may further comprise a blocker 133 for absorbing a zeroth order (*m* = *0*) of diffraction of the diffracted light.

The optical processor 13 may further comprise a sweep/scan controller 134 configured to control the AOD 131 in such a way that the pump or the probing light beam scans the medium 11 linearly with respect to its spatial dimension *X* (see description of FIG. 2 for details).

The system 1 further comprises an optical detector 15 configured to continuously detect an optical property of light emanating from the pumped medium 11. This is typically the probing light going through to reflected by sensing medium, the optical characteristics of the sensing medium (as detected by the probing light) being dependent on the e.g. the field strength of the RF signal to be analysed at a given location in the sensing medium.

In particular, the detector 15 may comprise at least one charge-coupled device, CCD, chip extending across a cross-section of the light emanating from the pumped medium 11. For example, if the detector 15 cannot measure continuously, it is possible to use two camera chips taking turns. The detected optical property may comprise a cross-sectional intensity distribution of the light emanating from the pumped medium 11.

The light emanating from the pumped medium 11 may comprise a probing( readout light) light transmission through the medium 11 having a cross-sectional intensity distribution depending on a frequency and field strength of the electromagnetic field of the RF signal.

According to the above-mentioned alternative implementation (not shown), the light emanating from the pumped medium 11 may comprise a light emission of the medium 11 having a directional intensity distribution depending on the frequency of the electromagnetic field of the RF signal.

In each section of the medium 11, a pulsed measurement is performed. Depending on a displacement *X(t)* of the pump light the measurement sequence starts at a different time *t.* While a particular section is being pumped/read out, there are still other sections interacting with the electromagnetic field of the RF signal.

From the detected optical property across all sections of the medium 11, a real-time measurement of the microwave is performed.

To this end, the system 1 may further comprise a digital processor 18 configured to reconstruct the RF signal in real-time in dependence of the detected optical property.

The system 1 further comprises a field generator 16 configured to expose the medium 11 to a static electric or magnetic field. A strength of the generated field defines an absorption spectrum of the medium 11.

In particular, the strength of the generated field has a gradient along a spatial dimension *X* of the medium 11.

In particular, the field generator 16 may comprise a permanent magnet. For example, FIG. 1 shows a pair of oppositely aligned permanent magnets 16 whose respective magnetic fields tend to cancel each other out halfway of their spacing. As a result, the strength of the generated magnetic field has a gradient along the spatial dimension *X* of the medium 11.

A presence of such an inhomogeneous magnetic field may cause Zeeman splitting, which ensures availability of atoms, ions or point defects in an initial state for each frequency in a desired frequency range, which may be included in a microwave frequency range ranging between 300 MHz and 300 GHz, respectively.

Zeeman splitting may refer to splitting of a spectral line, such as the initial state, into several components in the presence of a static magnetic field. Stark splitting, the electric-field analogue of Zeeman splitting, may refer to splitting of a spectral line into several components in the presence of a static electric field.

FIG. 2 illustrates a periodic displacement cycle in accordance with the present disclosure of the system 1 of FIG. 1.

Given an incidence of light at Bragg angle *θᵢₙ* from the perpendicular of the sound wave's propagation (note the angle of inclination of the AOD 131 in FIG. 1), ${θ}_{in} \approx {sinθ}_{in} = \frac{λ}{2 n Λ}$ a diffraction pattern may form in the AOD 131 where an order *m* = ..., -2, -1, 0, +1, +2, ... of diffraction (or diffracted beam) occurs at each angle *θₒᵤₜ* from the perpendicular of the sound wave's propagation that satisfies ${θ}_{out} \approx {sinθ}_{out} = m \frac{λ}{2 n Λ}$

Diffraction from a sinusoidal modulation in a thin crystal primarily results in the *m* = *-1, 0, +1* diffraction orders. FIG. 1 shows a diffraction order of *m* = +*1* varying in diffraction angle *α,* and a diffraction order of *m* = *0* (directed horizontally in FIG. 1).

A diffraction angle *α* = *θ*_{*out,m*=}*₊₁ - θ*_{*out,m*=*0*} of the diffracted light may be designed to vary over the displacement cycle in accordance with a linear transverse displacement of the pump light along the spatial dimension *X* of the medium 11. That is, by appropriate control of the diffraction angle *α* (or more specifically the sound wavelength *Λ*) over time *T,* a linearly evolving transverse displacement *X* of the pump light may be achieved, with respect to the displacement *X* = *0* of the zeroth order of diffraction, i.e., *m* = *0*: $α = {θ}_{out , m = + 1} - {θ}_{out , m = 0} \approx \frac{λ}{2 n Λ}$ $\begin{matrix}∝ \approx sin ∝ = \frac{X}{D} \\ ⇒ X \left(t\right) \approx \frac{λ}{2 n Λ \left(t\right)} D\end{matrix}$

This approximation applies for small angles *α* and *θ*ₒᵤₜ. An example of such a linearly evolving displacement *X* of the pump light over time *T* may be taken from FIG. 2.

The example shows multiple displacement cycles of period *T*. During each displacement cycle, the transverse displacement *X* of the pump light evolves linearly over time *T,* in accordance with the above mathematical description.

Continuously, there is a transverse displacement *X(T)* where the medium 11 is pumped and read out while the rest of the medium 11 may interact with the RF/microwave signal.

At the end of the sweep/scan/period, the pump beam may be turned off, reset to its initial position *X* = *0*, and turned on again.

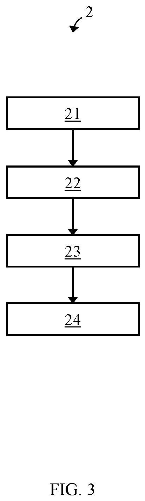

FIG. 3 illustrates a flow chart of a method 2 in accordance with the present disclosure for analyzing an RF signal.

The method 2 comprises pumping 21 at least one constituent of a sensing medium 11 to an initial energy state. The at least one constituent is further excitable from the initial energy state to a higher energy state by exposure to an electric and/or magnetic field.

The method 2 further comprises exposing 22 the medium 11 to an electromagnetic field of the RF signal.

The method 2 further comprises displacing 23 the pump 12 light transversely along a spatial dimension *X* of the medium 11 in accordance with a displacement cycle having a period *T* in the order of microseconds to milliseconds.

The method 2 further comprises continuously detecting 24 an optical property of light emanating from the pumped medium 11.

## Claims

1. A measurement system (1) for analyzing an RF signal, comprising
- a sensing medium (11), including at least one constituent being excitable from the initial energy state to a higher energy state by exposure to an electric and/or magnetic field;
- an optical pump (12) configured to pump the at least one constituent of the sensing medium (11) to an initial energy state;
- an antenna (14) configured to expose the sensing medium (11) to an electromagnetic field of the RF signal thus exciting the sensing medium (11);
- an optical processor (13) configured to displace a probing light transversely along at least one spatial dimension (X) of the sensing medium (11) in accordance with a displacement cycle; and
- an optical detector (15) configured to detect an optical property of light emanating from the pumped sensing medium (11) as a result of the probing light at different locations along the displacement dimension during the displacement of the pump light,
- wherein the optical processor (13) is configured to sweep the position of the probing light across the sensing medium (11) such that the sensing medium (11) is pumped and emanating light in one region and at the same time interacts with the RF signal in another region, during the displacement cycle,
**characterized by**:
- the displacement cycle having a period (T) in the order of microseconds to miliseconds, and
- the system further comprises a field generator (16) configured to expose the medium (11) to a static electric or magnetic field, a strength of which defining an absorption spectrum of the medium (11) and having a gradient along said spatial dimension (X) of the medium (11).

2. The system of claim 1,
wherein the probing light is produced by the optical pump (12) or by another probing light source, such as e.g. a laser.

3. The system (1) of claim 1 or 2,
the field generator (16) comprising a permanent magnet.

4. The system (1) of any one of the preceding claims,
the optical processor (13) comprising
- an acousto-optic deflector, AOD (131), for diffracting the generated light along the spatial dimension (X) of the medium (11), a diffraction angle (α) of the diffracted light varying over the displacement cycle in accordance with a linear transverse displacement of the pump light along the spatial dimension (X) of the medium (11); and
- a first optical lens (132) configured to collimate a higher order of diffraction of the diffracted light onto the medium (11).

5. The system (1) of claim 4,
the optical processor (13) further comprising
- a blocker (133) for absorbing a zeroth order of diffraction of the diffracted light.

6. The system (1) of any one of the claims 1 to 5,
the medium (11) comprising an alkali metal enclosed in an atomic vapor cell (17);
the at least one constituent of the medium (11) comprising atoms or ions in a buffer gas; and
the light emanating from the pumped medium (11) comprising a pump light transmission through the medium (11) having a cross-sectional intensity distribution depending on a frequency of the electromagnetic field of the RF signal.

7. The system (1) of any one of the claims 1 to 5,
the medium (11) comprising a Nitrogen vacancy, NV, diamond;
the at least one constituent of the medium (11) comprising point defects;
the light emanating from the pumped medium (11) comprising a light emission of the medium (11) having a directional intensity distribution depending on the frequency of the electromagnetic field of the RF signal; and
the system (1) further comprising a second optical lens configured to collimate the light emanating from the pumped medium (11) onto the detector (15).

8. The system (1) of any one of the preceding claims,
the pump (12) comprising at least one coherent optical light source.

9. The system (1) of any one of the preceding claims,
the detector (15) comprising at least one charge-coupled device, CCD, chip extending across a cross-section of the light emanating from the pumped medium (11); and
the detected optical property comprising a cross-sectional intensity distribution of the light emanating from the pumped medium (11).

10. The system (1) of any one of the preceding claims, further comprising
- a digital processor (18) configured to reconstruct the RF signal in real-time in dependence of the detected optical property.

11. A method (2) of analyzing an RF signal, comprising
- pumping (21) at least one constituent of a sensing medium (11) to an initial energy state by means of a pump light, the at least one constituent further being excitable from the initial energy state to a higher energy state by exposure to an electric and/or magnetic field;
- exposing (22) the sensing medium (11) to an electromagnetic field of the RF signal;
- displacing (23) a probing light source light transversely along at least one spatial dimension (X) of the sensing medium (11) in accordance with a displacement cycle; and
- during the displacement of the probing light, detecting (24) an optical property of light emanating from the pumped medium (11),
- wherein the method further comprises: sweeping the position of the probing light across the sensing medium (11) such that the sensing medium (11) is pumped and emanating light in one region and at the same time interacts with the RF signal in another region, during the displacement cycle,
**characterized by**:
- the displacement cycle having a period (T) in the order of microseconds to miliseconds, the method further comprising:
- exposing the medium (11) to a static electric or magnetic field, a strength of which defining an absorption spectrum of the medium (11), and having a gradient along said spatial dimension (X) of the medium (11).

## Patentansprüche

1. Messsystem (1) zum Analysieren eines HF-Signals, umfassend
- ein Sensormedium (11), einschließlich mindestens eines Bestandteils, der durch Aussetzen gegenüber einem elektrischen und/oder magnetischen Feld von einem anfänglichen Energiezustand in einen höheren Energiezustand erregbar ist;
- eine optische Pumpe (12), die konfiguriert ist, um den mindestens einen Bestandteil des Sensormediums (11) in den anfänglichen Energiezustand zu pumpen;
- eine Antenne (14), die konfiguriert ist, um das Sensormedium (11) einem elektromagnetischen Feld des HF-Signals auszusetzen und dadurch das Sensormedium (11) zu erregen;
- einen optischen Prozessor (13), der konfiguriert ist, um ein Sondenlicht quer entlang mindestens einer räumlichen Dimension (X) des Sensormediums (11) gemäß einem Verschiebungszyklus zu verschieben; und
- einen optischen Detektor (15), der konfiguriert ist, um eine optische Eigenschaft von Licht, das als Ergebnis des Sondenlichts von dem gepumpten Sensormedium (11) austritt, an verschiedenen Orten entlang der Verschiebungsdimension während der Verschiebung des Pumplichts zu detektieren,
- wobei der optische Prozessor (13) konfiguriert ist, um die Position des Sondenlichts über das Sensormedium (11) zu führen, sodass das Sensormedium (11) während des Verschiebungszyklus in einem Bereich gepumpt wird und Licht daraus austritt und es gleichzeitig mit dem HF-Signal in einem anderen Bereich interagiert,
**dadurch gekennzeichnet, dass**:
- der Verschiebungszyklus eine Periode (T) in der Größenordnung von Mikrosekunden bis Millisekunden aufweist und
- das System ferner einen Feldgenerator (16) umfasst, der konfiguriert ist, um das Medium (11) einem statischen elektrischen oder magnetischen Feld auszusetzen, dessen Stärke ein Absorptionsspektrum des Mediums (11) definiert und das einen Gradienten entlang der räumlichen Dimension (X) des Mediums (11) aufweist.

2. System nach Anspruch 1,
wobei das Sondenlicht durch die optische Pumpe (12) oder durch eine andere Sondenlichtquelle, wie z. B. einen Laser, erzeugt wird.

3. System (1) nach Anspruch 1 oder 2,
wobei der Feldgenerator (16) einen Permanentmagneten umfasst.

4. System (1) nach einem der vorstehenden Ansprüche,
wobei der optische Prozessor (13) umfasst
- einen akustooptischen Deflektor, AOD (131), zum Beugen des erzeugten Lichts entlang der räumlichen Dimension (X) des Mediums (11), wobei ein Beugungswinkel (α) des gebeugten Lichts über den Verschiebungszyklus gemäß einer linearen transversalen Verschiebung des Pumplichts entlang der räumlichen Dimension (X) des Mediums (11) variiert; und
- eine erste optische Linse (132), die konfiguriert ist, um eine höhere Beugungsordnung des gebeugten Lichts auf das Medium (11) zu kollimieren.

5. System (1) nach Anspruch 4,
wobei der optische Prozessor (13) ferner umfasst
- einen Blocker (133) zum Absorbieren einer nullten Beugungsordnung des gebeugten Lichts.

6. System (1) nach einem der Ansprüche 1 bis 5,
wobei das Medium (11) ein Alkalimetall umfasst, das in einer Atomdampfzelle (17) eingeschlossen ist;
wobei der mindestens eine Bestandteil des Mediums (11) Atome oder Ionen in einem Puffergas umfasst und
wobei das Licht, das von dem gepumpten Medium (11) austritt, eine Pumplichtdurchlässigkeit durch das Medium (11) umfasst, die eine Querschnittsintensitätsverteilung, die von einer Frequenz des elektromagnetischen Felds des HF-Signals abhängt, aufweist.

7. System (1) nach einem der Ansprüche 1 bis 5,
wobei das Medium (11) einen Diamanten mit Stickstoffvakanz, NV, umfasst;
der mindestens eine Bestandteil des Mediums (11) Punktdefekte umfasst;
das Licht, das von dem gepumpten Medium (11) austritt, eine Lichtemission des Mediums (11) umfasst, die eine gebündelte Intensitätsverteilung, die von des Frequenz des elektromagnetischen Felds des HF-Signals abhängt, aufweist; und
wobei das System (1) ferner eine zweite optische Linse umfasst, die konfiguriert ist, um das Licht, das von dem gepumpten Medium (11) austritt, auf den Detektor (15) zu kollimieren.

8. System (1) nach einem der vorstehenden Ansprüche,
wobei die Pumpe (12) mindestens eine kohärente optische Lichtquelle umfasst.

9. System (1) nach einem der vorstehenden Ansprüche,
wobei der Detektor (15) mindestens einen Charge-Coupled-Device-Chip, CCD-Chip, umfasst, der sich über einen Querschnitt des von dem gepumpten Medium (11) austretenden Lichts erstreckt; und
wobei die detektierte optische Eigenschaft eine Querschnittsintensitätsverteilung des von dem gepumpten Medium (11) austretenden Lichts umfasst.

10. System (1) nach einem der vorstehenden Ansprüche, ferner umfassend
- einen digitalen Prozessor (18), der konfiguriert ist, um das HF-Signal in Echtzeit in Abhängigkeit von der detektierten optischen Eigenschaft zu rekonstruieren.

11. Verfahren (2) zum Analysieren eines HF-Signals, umfassend
- Pumpen (21) mindestens eines Bestandteils eines Sensormediums (11) in einen anfänglichen Energiezustand mittels eines Pumplichts, wobei der mindestens eine Bestandteil ferner durch Aussetzen gegenüber einem elektrischen und/oder magnetischen Feld von dem anfänglichen Energiezustand in einen höheren Energiezustand erregbar ist;
- Aussetzen (22) des Sensormediums (11) gegenüber einem elektromagnetischen Feld des HF-Signals;
- Verschieben (23) eines Lichts einer Sondenlichtquelle quer entlang mindestens einer räumlichen Dimension (X) des Sensormediums (11) gemäß einem Verschiebungszyklus und
- während der Verschiebung des Sondenlichts Detektieren (24) einer optischen Eigenschaft von Licht, das von dem gepumpten Medium (11) austritt,
- wobei das Verfahren ferner umfasst: Führen der Position des Sondenlichts über das Sensormedium (11), sodass das Sensormedium (11) während des Verschiebungszyklus in einem Bereich gepumpt wird und Licht daraus austritt und gleichzeitig mit dem HF-Signal in einem anderen Bereich interagiert,
**dadurch gekennzeichnet, dass**:
- der Verschiebungszyklus eine Periode (T) in der Größenordnung von Mikrosekunden bis Millisekunden aufweist, wobei das Verfahren ferner umfasst:
- Aussetzen des Mediums (11) gegenüber einem statischen elektrischen oder magnetischen Feld, dessen Stärke ein Absorptionsspektrum des Mediums (11) definiert und das einen Gradienten entlang der räumlichen Dimension (X) des Mediums (11) aufweist.

## Revendications

1. Système de mesure (1) permettant d'analyser un signal RF, comprenant
- un milieu (11) de captage, comportant au moins un constituant qui peut être excité de l'état énergétique initial à un état énergétique supérieur par exposition à un champ électrique et/ou magnétique ;
- une pompe (12) optique configurée pour pomper l'au moins un constituant du milieu (11) de captage jusqu'à un état énergétique initial ;
- une antenne (14) configurée pour exposer le milieu (11) de captage à un champ électromagnétique du signal RF, excitant ainsi le milieu (11) de captage ;
- un processeur optique (13) configuré pour déplacer de la lumière de sondage transversalement le long d'au moins une dimension spatiale (X) du milieu (11) de captage conformément à un cycle de déplacement ; et
- un détecteur (15) optique configuré pour détecter une propriété optique de lumière émanant du milieu (11) de captage pompé sous l'effet de la lumière de sondage au niveau de différents emplacements le long de la dimension de déplacement pendant le déplacement de la lumière de pompage,
- dans lequel le processeur optique (13) est configuré pour balayer la position de la lumière de sondage à travers le milieu (11) de captage de telle sorte que le milieu (11) de captage soit pompé et émette de la lumière dans une région et interagisse en même temps avec le signal RF dans une autre région, pendant le cycle de déplacement,
**caractérisé par** :
- le cycle de déplacement ayant une période (T) de l'ordre de microsecondes à des millisecondes, et
- le système comprend en outre un générateur de champ (16) configuré pour exposer le milieu (11) à un champ électrique ou magnétique statique, dont une intensité définit un spectre d'absorption du milieu (11) et ayant un gradient le long de ladite dimension spatiale (X) du milieu (11).

2. Système selon la revendication 1,
dans lequel la lumière de sondage est produite par la pompe (12) optique ou par une autre source de lumière de sondage, telle que, par exemple, un laser.

3. Système (1) selon la revendication 1 ou 2,
le générateur de champ (16) comprenant un aimant permanent.

4. Système (1) selon l'une quelconque des revendications précédentes,
le processeur optique (13) comprenant
- un déflecteur acousto-optique, AOD (131), destiné à diffracter la lumière générée le long de la dimension spatiale (X) du milieu (11), un angle de diffraction (α) de la lumière diffractée variant au cours du cycle de déplacement conformément à un déplacement transversal linéaire de la lumière de pompage le long de la dimension spatiale (X) du milieu (11) ; et
- une première lentille optique (132) configurée pour collimater un ordre de diffraction supérieur de la lumière diffractée sur le milieu (11).

5. Système (1) selon la revendication 4,
le processeur optique (13) comprenant en outre
- un bloqueur (133) destiné à absorber une diffraction d'ordre zéro de la lumière diffractée.

6. Système (1) selon l'une quelconque des revendications 1 à 5,
le milieu (11) comprenant un métal alcalin enfermé dans une cellule de vapeur atomique (17) ;
l'au moins un constituant du milieu (11) comprenant des atomes ou ions dans un gaz tampon ; et
la lumière émanant du milieu (11) pompé comprenant une transmission de lumière de pompage à travers le milieu (11) ayant une distribution d'intensité en section transversale dépendant d'une fréquence du champ électromagnétique du signal RF.

7. Système (1) selon l'une quelconque des revendications 1 à 5,
le milieu (11) comprenant un diamant à azote-lacune, NV ;
l'au moins un constituant du milieu (11) comprenant des défauts ponctuels ;
la lumière émanant du milieu (11) pompé comprenant une émission de lumière du milieu (11) ayant une distribution d'intensité directionnelle dépendant de la fréquence du champ électromagnétique du signal RF ; et
le système (1) comprenant en outre une seconde lentille optique configurée pour collimater la lumière émanant du milieu (11) pompé sur le détecteur (15).

8. Système (1) selon l'une quelconque des revendications précédentes,
la pompe (12) comprenant au moins une source de lumière optique cohérente.

9. Système (1) selon l'une quelconque des revendications précédentes,
le détecteur (15) comprenant au moins une puce de dispositif à couplage de charge, CCD, qui s'étend à travers une section transversale de la lumière émanant du milieu (11) pompé ; et
la propriété optique détectée comprenant une distribution d'intensité en section transversale de la lumière émanant du milieu (11) pompé.

10. Système (1) selon l'une quelconque des revendications précédentes, comprenant en outre
- un processeur numérique (18) configuré pour reconstruire le signal RF en temps réel en fonction de la propriété optique détectée.

11. Procédé (2) d'analyse d'un signal RF, comprenant
- le pompage (21) d'au moins un constituant d'un milieu (11) de captage jusqu'à un état énergétique initial au moyen de lumière de pompage, l'au moins un constituant pouvant en outre être excité de l'état énergétique initial à un état énergétique supérieur par exposition à un champ électrique et/ou magnétique ;
- l'exposition (22) du milieu (11) de captage à un champ électromagnétique du signal RF ;
- le déplacement (23) de lumière de source de lumière de sondage transversalement le long d'au moins une dimension spatiale (X) du milieu (11) de captage conformément à un cycle de déplacement ; et
- lors du déplacement de la lumière de sondage, la détection (24) d'une propriété optique de lumière émanant du milieu (11) pompé,
- dans lequel le procédé comprend en outre : le balayage de la position de la lumière de sondage à travers le milieu (11) de captage de telle sorte que le milieu (11) de captage soit pompé et émette de la lumière dans une région et interagisse en même temps avec le signal RF dans une autre région, pendant le cycle de déplacement,
**caractérisé par** :
- le cycle de déplacement ayant une période (T) de l'ordre de microsecondes à des millisecondes, le procédé comprenant en outre :
- l'exposition du milieu (11) à un champ électrique ou magnétique statique, dont une intensité définit un spectre d'absorption du milieu (11) et ayant un gradient le long de ladite dimension spatiale (X) du milieu (11).
